(19) Europäisches Patentamt / European Patent Office / Office européen des brevets

(11) **EP 2 177 944 B1**

(12) **FASCICULE DE BREVET EUROPEEN**

(45) Date de publication et mention de la délivrance du brevet:
**19.07.2017 Bulletin 2017/29**

(51) Int Cl.:
*G02F 1/025* (2006.01)   *H01L 21/266* (2006.01)
*G02B 6/134* (2006.01)

(21) Numéro de dépôt: **09172882.4**

(22) Date de dépôt: **13.10.2009**

(54) **Procédé de fabrication d'un modulateur électro-optique latéral sur silicium à zones implantées auto-alignées**

Herstellungsverfahren eines seitlichen elektrooptischen Modulators auf Silizium mit selbstausgerichteten, dotierten Bereichen

Method of manufacturing a lateral electro-optical modulator on silicon with self-aligned doped regions

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **17.10.2008 FR 0857059**

(43) Date de publication de la demande:
**21.04.2010 Bulletin 2010/16**

(73) Titulaire: **Commissariat à l'Énergie Atomique et aux Énergies Alternatives 75015 Paris (FR)**

(72) Inventeur: **Fedeli, Jean-Marc 38120 SAINT EGREVE (FR)**

(74) Mandataire: **Ilgart, Jean-Christophe et al BREVALEX 95, rue d'Amsterdam 75378 Paris Cedex 8 (FR)**

(56) Documents cités:
**GB-A- 2 373 370     GB-A- 2 373 921 US-A1- 2003 013 242     US-A1- 2008 124 870**

- **MARRIS-MORINI D ET AL: "Low loss and high speed silicon optical modulator based on a lateral carrier depletion structure" OPTICS EXPRESS 20080107 OPTICAL SOCIETY OF AMERICA US, vol. 16, no. 1, 7 janvier 2008 (2008-01-07), pages 334-339, XP002530622**

**Description**

## DOMAINE TECHNIQUE

L'invention se situe dans le domaine de la photonique sur silicium. Elle concerne la fabrication d'un modulateur électro-optique permettant de moduler l'intensité d'une source continue de lumière à haute fréquence. La présente invention se rapporte plus particulièrement à la fabrication d'un modulateur de lumière aux longueurs d'ondes des télécommunications optiques (supérieures à 1,2 $\mu$m) fabriqué entièrement en silicium. Le modulateur selon la présente invention est intégrable dans un guide d'onde optique dont la section peut être submicronique, et peut fonctionner à des fréquences élevées (de l'ordre de plusieurs dizaines de GHz). La technologie employée est compatible avec la technologie microélectronique.

## ÉTAT DE LA TECHNIQUE ANTÉRIEURE

L'expression « Photonique sur Silicium » regroupe les études basées sur le guidage de lumière dans des guides à fort indice dans des dimensions nanométriques sur plaquettes de silicium. Le concept de base est de réaliser des fonctions optiques à forte intégration sur silicium. Parmi les briques de base, on peut citer le laser constituant une source lumineuse à une longueur d'onde spécifique. Pour moduler cette source en intensité, on peut moduler directement le courant de commande, mais cela conduit à des fréquences de fonctionnement limitées et à des variations de longueurs d'onde. Une solution plus performante est d'adjoindre à une source continue bien contrôlée en longueur d'onde, un modulateur électro-optique qui va moduler l'intensité du signal lumineux.

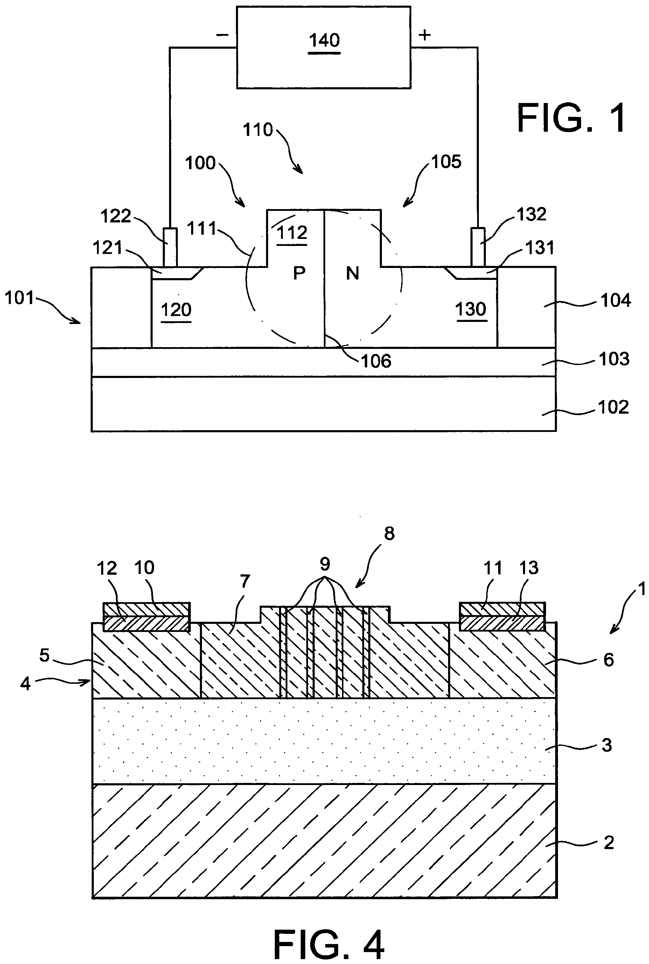

Le document US 7 251 408 divulgue un modulateur latéral sur silicium formé par une jonction PN centrée au milieu de l'arête d'un guide d'onde. La figure 1 de ce document, reproduite à la figure 1 des dessins annexés, montre un modulateur optique 100 constitué d'une diode latérale 105 fabriquée dans un guide d'onde 110 sur un substrat 101. Le substrat 101 est un substrat SOI comprenant un support 102 en silicium, supportant successivement une couche d'oxyde de silicium (ou couche d'oxyde enterrée) 103 et une couche mince de silicium 104. Le guide d'onde 110 comprend la couche mince 104 et l'arête 112. Une diode est formée entre les contacts électriques 121 et 131. Le confinement vertical de l'onde optique est obtenu par le contraste optique existant la couche de silicium 104, la couche d'oxyde enterrée 103 et une couche de matériau diélectrique déposée sur le guide d'onde 110 et non représentée sur la figure 1. La ligne en traits interrompus 111 représente la section transversale du guide d'onde dans laquelle se propage la majorité de la puissance du mode optique guidé. La diode 105 possède deux régions dopées 120 et 130. Les dopages des régions 120 et 130 sont de type opposé.

Les deux régions dopées 120 et 130 se rencontrent à la jonction PN 106 qui est approximativement le centre du guide d'onde 110. Des plots conducteurs 122 et 132 se connectent respectivement aux régions dopées 120 et 130 par l'intermédiaire de contacts électriques 121 et 131.

En l'absence de tension appliquée, la diode 105 présente une région de déplétion de porteurs relativement étroite. En polarisant la diode 105 en inverse par une tension fournie par le générateur 140, on augmente la largeur de la zone de déplétion dans la diode 105, ce qui provoque un changement de l'indice effectif de réfraction du guide d'onde 110 et un décalage de phase de l'onde optique se propageant dans le guide d'onde 110.

Le document US 7 116 853 propose un modulateur latéral sur silicium, du même type que celui qui vient d'être décrit et qui a pour objet d'optimiser le profil de dopage par modulation graduelle du dopage latéral.

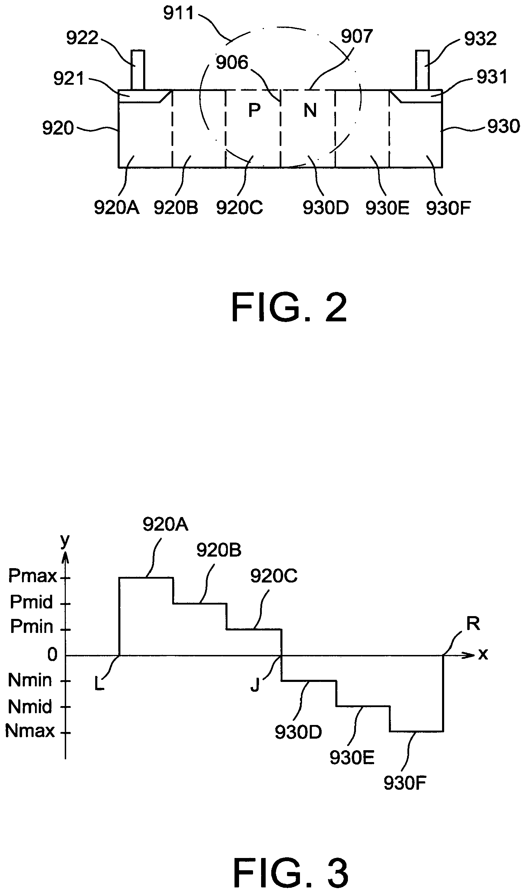

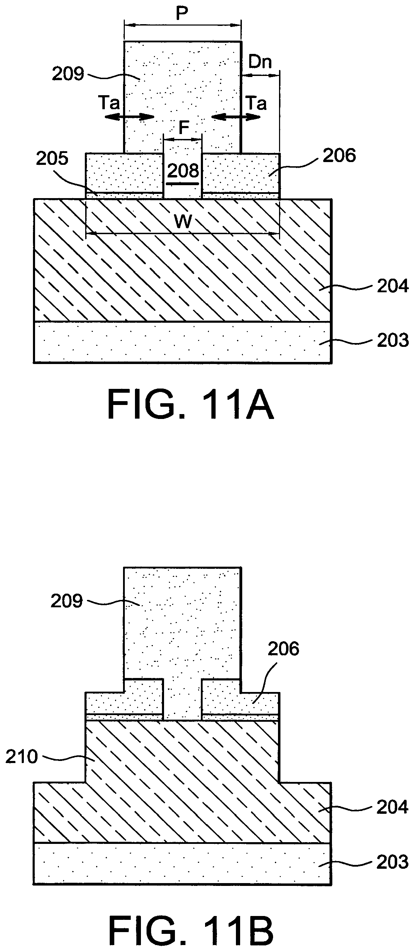

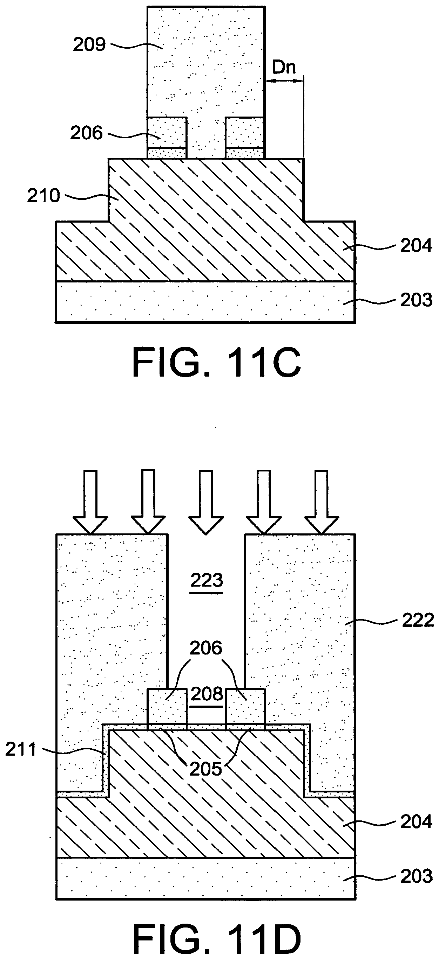

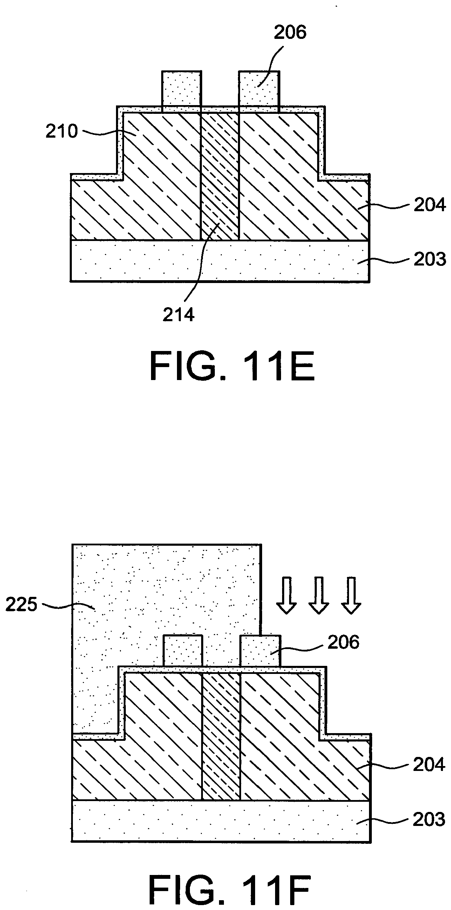

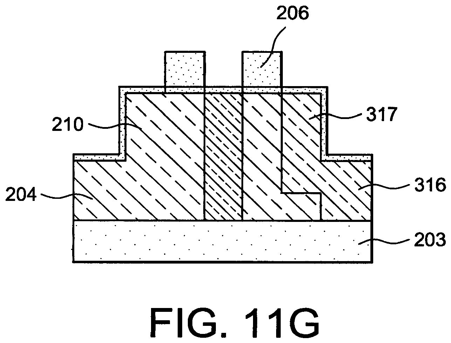

Les figures 11 et 12 de ce document, reproduites respectivement sur les figures 2 et 3 annexées, illustrent cette optimisation du profil de dopage de la diode. Sur la figure 2, on reconnaît une diode PN formée dans la couche mince de silicium et constituée de deux régions 920 et 930 dopées d'un type opposé de dopage. La région 920 comporte un contact électrique 921 de connexion avec un plot conducteur 922. La région 930 comporte un contact électrique 931 de connexion avec un plot conducteur 932. La jonction PN 906 résulte de la rencontre des régions 920 et 930. Le trait interrompu 907 représente la frontière supérieure de la région active de silicium. La ligne en traits interrompus 911 représente la section transversale du guide d'onde dans laquelle se propage la majorité de la puissance du monde optique guidé. La région 920 comprend des sections 920A, 920B et 920C de même dopage mais de niveaux de concentration de dopants différents. De même, la région 930 comprend des sections 930D, 930E et 930F de même dopage mais de niveaux de concentration de dopants différents.

La figure 3 est un graphe montrant les concentrations en dopants des régions dopées 920 et 930. L'axe x de la figure 3 reproduit l'axe horizontal de la figure 2. L'axe y de la figure 3 reproduit la polarité et le niveau relatif de la concentration en dopants des régions dopées de la figure 2. Le point L sur l'axe des x représente la frontière gauche de la région 920 sur la figure 2. Le point J sur l'axe des x représente le centre de la diode PN sur la figure 2. Le point R sur l'axe des x représente la frontière droite de la région 930 sur la figure 2. Sur la figure 3, $P_{max}$ est le plus haut niveau de dopants de type P, dans la section 920A, $P_{min}$ est le plus faible niveau de dopants de type P, dans la section 920B, et $P_{mid}$ est un niveau moyen de dopants de type P, dans la section 920C. $N_{max}$ est le plus haut niveau de dopants de type N, dans la section 930F, $N_{min}$ est le plus bas niveau de dopants de type N, dans la section 930D, et $N_{mid}$ est un niveau moyen de dopants de type N, dans la section 930E.

La difficulté de cette approche réside dans la localisation précise des sections implantées par rapport au centre de l'arête en considérant les tolérances de fabrication.

Le document WO-A-2005/093 480 divulgue un modulateur électro-optique réalisé sur un substrat SOI et constitué à partir d'un guide d'onde en arête. La structure proposée comporte un ou plusieurs plans de dopage verticaux et des zones de contacts latérales dopées N$^+$ et P$^+$ et situées de part et d'autre du guide. Ce modulateur électro-optique est représenté en coupe transversale sur la figure 4. Il est réalisé à partir d'un substrat SOI 1 comprenant un support 2 en silicium supportant successivement une couche d'oxyde de silicium 3 (couche d'oxyde enterrée) et une couche mince de silicium 4. Pour obtenir ce modulateur, une cuvette est gravée dans la couche mince de silicium 4 en laissant subsister une épaisseur minimale de silicium pour la reprise d'épitaxie. La structure est ensuite réalisée par croissance épitaxiale sélective de silicium. Elle comprend, réalisées au-dessus de la couche d'oxyde enterrée 3, une région 5 dopée P$^+$ et une région 6 dopée N$^+$ entre lesquelles se trouve une région non intentionnellement dopée 7 où est réalisé le guide d'onde en arête 8. L'ensemble constitue une diode PIN. La zone active de la diode est formée d'une pluralité de couches très minces de silicium 9 placées perpendiculairement au substrat, soit dopées N$^+$, soit dopées P$^+$. Une tension de polarisation peut être appliquée à la diode grâce à des électrodes métalliques 10 et 11 formées respectivement sur les régions dopées 5 et 6. Le contact électrique peut être amélioré par la formation d'un siliciure de nickel ou de platine. La figure 4 montre une couche de siliciure 12 formée entre la région dopée 5 et l'électrode 10, et une couche de siliciure 13 formée entre la région dopée 6 et l'électrode 11.

Cette structure a été fabriquée et est discutée dans l'article « Low loss and high speed silicon optical modulator based on a lateral carrier depletion structure » de D. MARRIS-MORINI et al., Optics Express, vol. 16, n°1, 7 janvier 2008, pages 334 à 339.

Parmi les avantages annoncés, on peut citer un fonctionnement sous faible courant électrique et un fonctionnement très rapide.

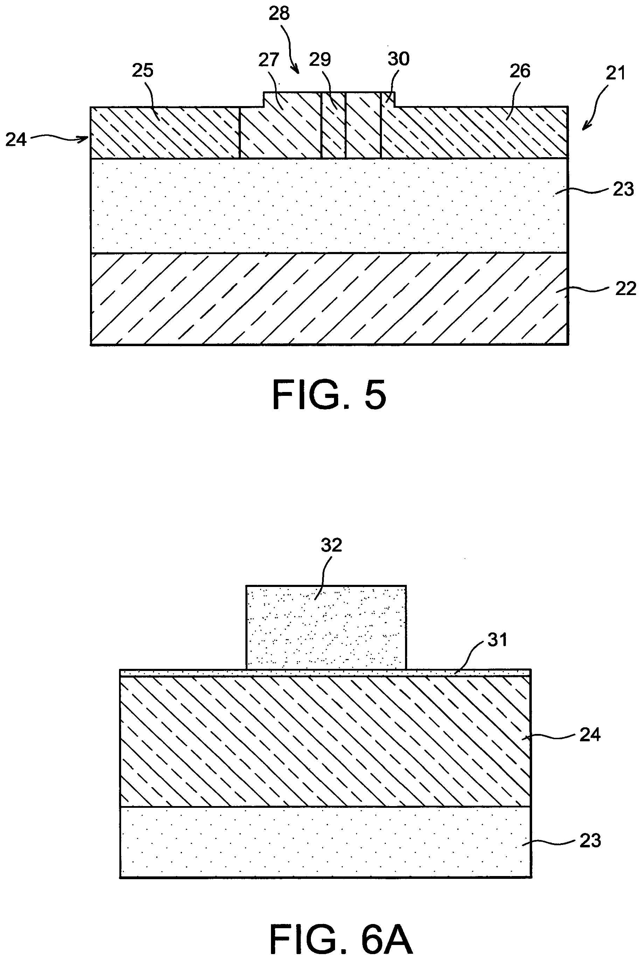

L'article de D. MARRIS-MORINI et al., cité ci-dessus propose le modulateur électro-optique représenté en coupe transversale à la figure 5. Il est réalisé à partir d'un substrat SOI 21 comprenant un support 22 en silicium supportant successivement une couche d'oxyde enterrée 23 de 1 μm d'épaisseur et une couche mince de silicium 24 de 300 nm d'épaisseur. A partir de cette couche mince, on a réalisé une région 25 dopée P et une région 26 dopée N entre lesquelles se trouve une région intrinsèque 27 où est réalisé le guide d'onde en arête 28. La largeur de l'arête est de 660 nm et son dépassement au-dessus des régions dopées N et P est de 100 nm. La zone centrale 29 du guide d'onde est dopée P et occupe une largeur de 100 nm. Cette zone centrale 29 sert de source de trous. La région dopée 26 déborde légèrement sur la partie droite de l'arête et y occupe une zone 30.

Les figures 6A à 6G sont des vues en coupe transversale illustrant partiellement le procédé de fabrication d'un tel modulateur électro-optique selon l'art connu.

La figure 6A montre la couche d'oxyde enterrée 23 d'un substrat SOI (le support en silicium n'est pas représenté par souci de simplification) supportant la couche mince en silicium 24. Une fine couche d'oxyde de silicium 31 est formée par oxydation thermique sur la couche mince de silicium 24. Pour obtenir l'arête du guide d'onde, on réalise par lithographie un masque de résine 32.

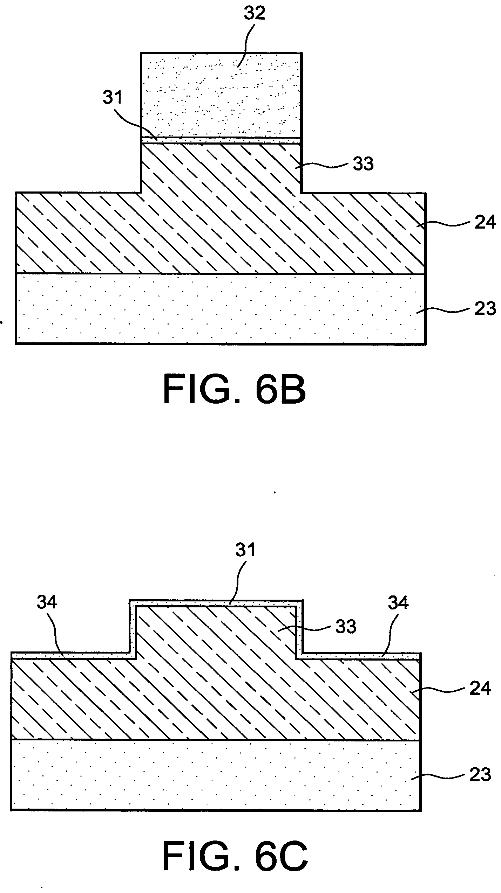

Les régions non masquées sont gravées, d'abord la fine couche d'oxyde 31 puis la couche mince de silicium 24. On obtient l'arête 33 du guide d'onde comme le montre la figure 6B.

Le masque de résine est éliminé et les parties mises à nu de la couche mince de silicium 24 sont soumises à une oxydation thermique pour les recouvrir d'une fine couche d'oxyde de silicium 34 comme le montre la figure 6C.

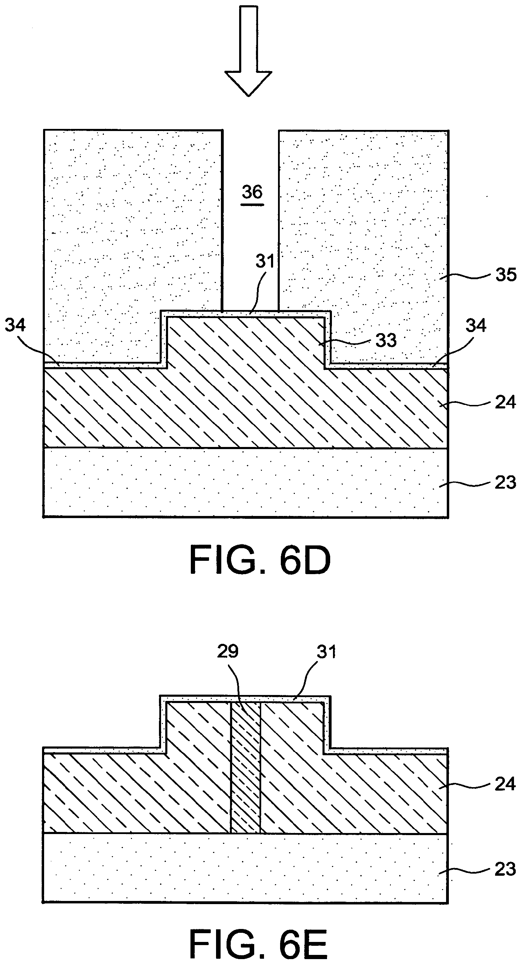

Une couche de résine 35 est alors déposée sur la structure obtenue précédemment et lithographiée pour former un masque pourvu d'une fente 36 juste au-dessus de la partie centrale de l'arête 33. C'est ce que montre la figure 6D. Une implantation de bore est alors réalisée dans la partie centrale de l'arête 33 au travers de la fente 36 et de la fine couche d'oxyde 31.

La résine est éliminée et on obtient la structure représentée à la figure 6E qui montre une zone 29 dopée P au centre de l'arête 33.

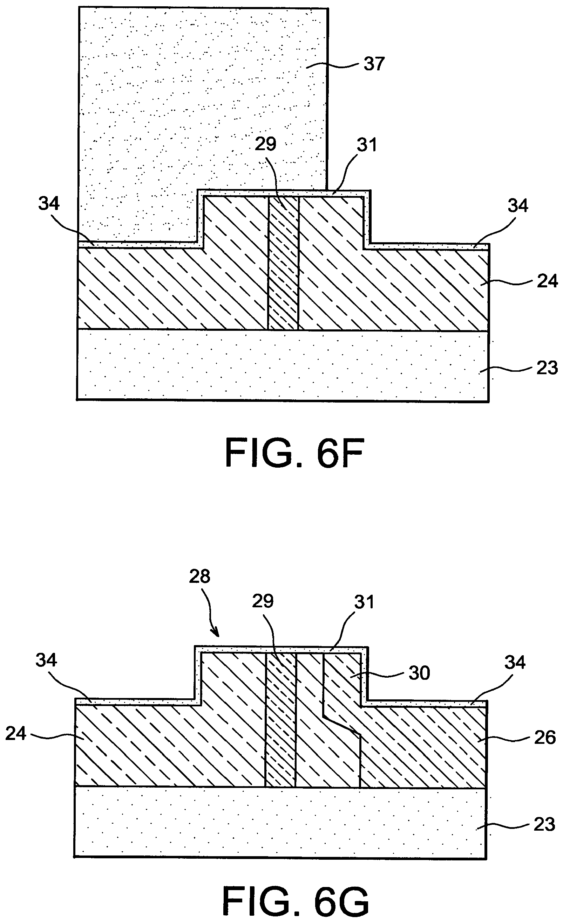

Une nouvelle couche de résine est déposée sur la structure obtenue précédemment. Cette couche de résine est lithographiée pour obtenir le masque 37 montrée à la figure 6F. Ce masque ne recouvre pas une partie située à droite de l'arête 33 ainsi que la partie de la couche mince de silicium 24 située à droite de l'arête 33.

On réalise une implantation d'ions phosphore dans les parties non masquées de la couche de silicium 24, au travers des fines couches d'oxyde 31 et 34. Le résultat obtenu est montré à la figure 6G, après élimination de la résine. Sur cette figure, on reconnaît la région dopée N 26 débordant en une zone 30 sur la partie droite de l'arête 33.

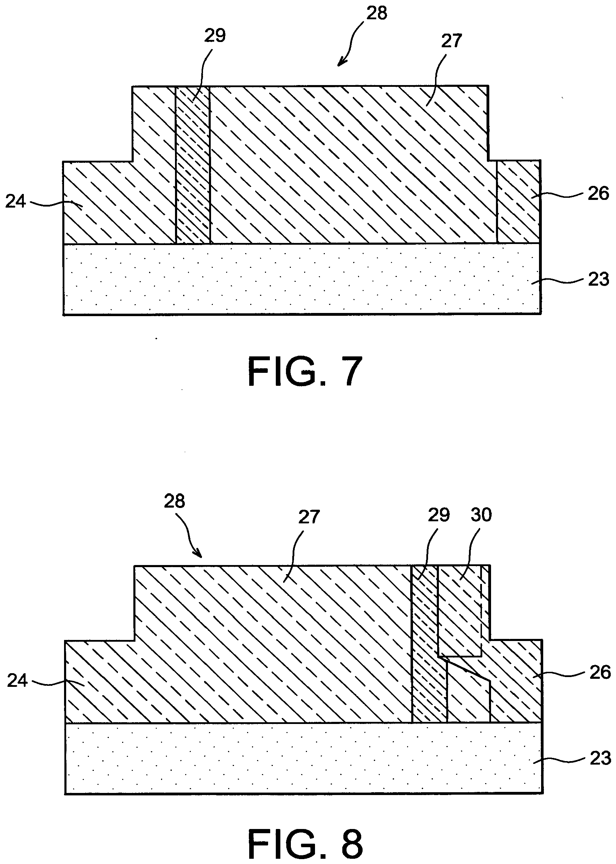

Le défaut majeur de ce procédé selon l'art connu est l'absence d'alignement des zones implantées avec l'arête du guide d'onde. Comme la formation du guide d'onde en arête 28 et des deux zones dopées 29 et 30 (voir la figure 6G) font appel à trois niveaux de masquage distincts, la précision à obtenir sur l'alignement est extrêmement élevée. Dans les pires cas, les zones implantées P (zone 29) et N (zone 30) sont soit très éloignées l'une de l'autre, soit très rapprochées. Un premier cas extrême est représenté à la figure 7 où la zone dopée P 29 est décalée sur la partie gauche de l'arête 27 et où la zone dopée N est confondue avec la région 26. Un deuxième cas extrême est représenté à la figure 8 où la zone dopée P 29 est décalée sur la partie droite de l'arête 27 et chevauche la zone dopée N 30. Dans ce dernier cas, on obtient une diode PN et non plus une diode PIN. Cette incertitude sur la position des zones 29 et 30 est très dommageable au niveau de la reproductibilité des performances et grève la possibilité d'une fabrication de masse où la plus grande tolérance est recherchée afin d'augmenter les rendements.

La même constatation s'applique aussi aux modulateurs divulgués dans les brevets US 7 251 408 et US 7 116 853 où l'on cherche à centrer la jonction PN et à contrôler la largeur des différentes zones dopées.

GB-A-2 373 921 divulgue un procédé de fabrication d'un modulateur électro-optique latéral sur un substrat SOI, le modulateur comprenant un guide d'onde en arête. Ce procédé comprend une étape de masquage mettant en oeuvre un masque mettant en oeuvre un masque dur permettant de définir l'arête du guide d'onde.

## EXPOSÉ DE L'INVENTION

Pour remédier au problème exposé ci-dessus, il est proposé, selon la présente invention, un procédé de fabrication procurant un auto-alignement des parties implantées N et P.

L'invention a donc pour objet un procédé de fabrication d'un modulateur électro-optique latéral sur un substrat SOI tel que défini dans la revendication 1, le modulateur comprenant un guide d'onde en arête formé dans la couche mince de silicium du substrat SOI, le guide d'onde en arête étant placé entre une région dopée P et une région dopée N formées dans la couche mince de silicium, le guide d'onde en arête occupant une région intrinsèque de la couche mince, la région dopée P, la région intrinsèque et la région dopée N constituant une structure de diode PIN, au moins une zone dopée P étant formée dans l'arête et perpendiculairement au substrat, le procédé comprenant des étapes de masquage de la couche mince de silicium, mettant en oeuvre un masque dur (206) dont le motif permet d'y définir l'arête du guide d'onde.

Par masque dur, on entend un masque réalisé en un matériau qui ne s'élimine pas lors de l'élimination de masques en résine couramment utilisés dans la technique.

Le masque dur peut être formé par gravure d'une couche de matériau de masque dur. Ce masque dur peut être en silice, en titane ou en nitrure de silicium.

Avantageusement, le motif du masque dur présente des bords extérieurs qui définissent l'arête du guide d'onde, une fente interne qui définit la zone à doper P dans l'arête du guide d'onde, l'un desdits bords extérieurs définissant la limite de la région dopée N par rapport à l'arête du guide d'onde.

Selon un mode particulier de mise en oeuvre, le procédé comprend la succession d'étapes suivantes :

- formation d'un premier masque de résine sur le masque dur, le premier masque de résine recouvrant la fente du masque dur et étant en retrait par rapport aux bords extérieurs du masque dur qui définissent l'arête du guide d'onde,
- gravure des parties non masquées de la couche mince de silicium pour obtenir l'arête du guide d'onde,
- élimination du premier masque de résine,
- formation d'un deuxième masque de résine masquant les parties de la structure ne devant pas être dopées P, le deuxième masque de résine comprenant une fente dont les bords sont en retrait par rapport aux bords de la fente du masque dur,
- réalisation du dopage P des parties non masquées de la couche mince de silicium,
- élimination du deuxième masque de résine,
- formation d'un troisième masque de résine masquant les parties de la structure ne devant pas être dopées N, le bord du troisième masque de résine du côté de la région à doper N étant en retrait par rapport au bord correspondant du masque dur,
- réalisation du dopage N des parties non masquées de la couche mince de silicium,
- élimination du troisième masque de résine,
- élimination du masque dur.

Le dopage N peut être réalisé par implantation ionique selon un angle de 0° par rapport à une direction verticale au substrat SOI. Il peut aussi être réalisé par implantation ionique selon un angle déterminé par rapport à une direction verticale au substrat SOI afin de doper le flanc de l'arête du guide d'onde adjacent à la région dopée N. Il peut aussi être obtenu par une implantation plasma qui crée de manière isotrope une zone implantée de profondeur contrôlée dans le silicium.

Selon un autre mode particulier de mise en oeuvre, le procédé comprend en outre, entre l'étape de gravure de la couche mince de silicium et l'étape d'élimination du premier masque de résine, une étape de gravure complète des parties du masque dur non masquées par le premier masque de résine.

## BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1, déjà décrite, représente un modulateur électro-optique latéral réalisé sur un substrat SOI, selon l'art connu,
- les figures 2 et 3, déjà décrites, illustrent une manière d'optimiser le profil de dopage de la diode latérale réalisée dans l'arête du guide d'onde pour un modulateur électro-optique selon l'art connu,
- la figure 4, déjà décrite, représente un autre modulateur électro-optique latéral réalisé sur un substrat SOI, selon l'art connu,

- la figure 5, déjà décrite, représente encore un autre modulateur électro-optique latéral réalisé sur un substrat SOI, selon l'art antérieur,

- les figures 6A à 6G, déjà décrites, sont des vues en coupe transversale illustrant partiellement le procédé de fabrication du modulateur électro-optique représenté à la figure 5, selon l'art connu,

- les figures 7 et 8 illustrent deux cas extrêmes d'absence d'alignement de zones implantées par rapport à l'arête du guide d'onde pour un modulateur électro-optique fabriqué par le procédé illustré par les figures 6A à 6G,

- les figures 9A à 9J sont des vues en coupe transversale illustrant un premier mode de réalisation d'un modulateur électro-optique latéral sur silicium, selon la présente invention,

- les figures 9I' et 9J' sont des vues en coupe transversale illustrant une variante du premier mode de réalisation d'un modulateur électro-optique latéral sur silicium, selon la présente invention,

- les figures 10A et 10B sont des vues en coupe transversale illustrant, en cas de besoin, une arête possédant plusieurs zones implantées de type P, selon la présente invention,

- les figures 11A à 11G sont des vues en coupe transversale illustrant un deuxième mode de réalisation d'un modulateur électro-optique latéral sur silicium, selon la présente invention.

## EXPOSÉ DÉTAILLÉ DE MODES DE RÉALISATION DE LA PRESENTE INVENTION

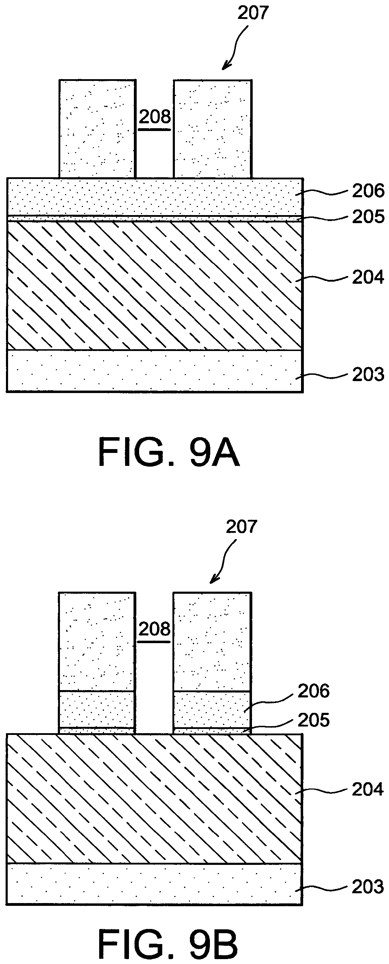

Les figures 9A à 9J sont des vues en coupe transversale illustrant un premier mode de réalisation d'un modulateur électro-optique latéral sur silicium, selon la présente invention.

Le modulateur est réalisé sur un substrat SOI comportant un support en silicium (non représenté par souci de simplification) supportant successivement une couche d'oxyde enterrée 203 et une couche mince de silicium 204. Sur la couche mince de silicium 204, on forme successivement une fine couche d'oxyde de silicium 205 et, par LPCVD, une couche de silice 206 formant masque dur (voir la figure 9A). Ce masque dur pourrait aussi être réalisé en titane ou en nitrure de silicium. Sur le masque dur 206, on forme par lithographie un masque de résine 207 présentant une fente 208 pour la définition de la zone dopée P.

On réalise ensuite une gravure des parties non masquées du masque dur 206 et de la fine couche d'oxyde de silicium 205 jusqu'à révéler la couche mince de silicium 204 (voir la figure 9B).

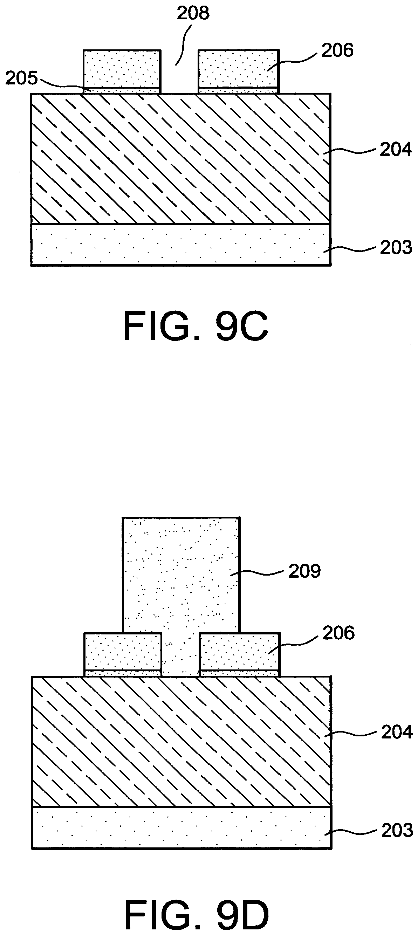

Le masque de résine est ensuite éliminé comme le montre la figure 9C.

On procède ensuite à la définition lithographique permettant de protéger la fente 208 pendant l'étape de gravure de l'arête du guide d'onde. La figure 9D montre le masque de lithographie 209 ainsi formé. La tolérance d'alignement du masque de lithographie par rapport au masque dur de silice 206 est de Ta = ±(W-F)/4. A titre d'exemple, W = 500 nm, F = 100 nm, donc Ta = ± 100 nm.

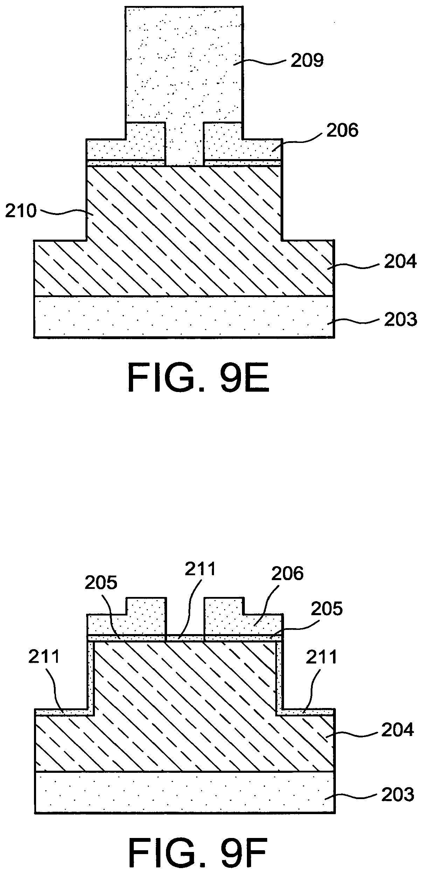

La structure obtenue précédemment est soumise à une étape de gravure du silicium de la couche 204 pour définir l'arête 210 nécessaire pour le guidage optique. C'est ce qui est représenté à la figure 9E. Pendant la gravure du silicium, le masque dur 206 a été partiellement consommé dans sa partie non masquée par le masque de lithographie 209, ce qui se traduit par un profil en forme de marche.

Le masque de résine 209 est ensuite éliminé et une fine couche d'oxyde de silicium 211 est formée sur la couche mince de silicium 204 qui a été révélée précédemment. C'est ce que montre la figure 9F.

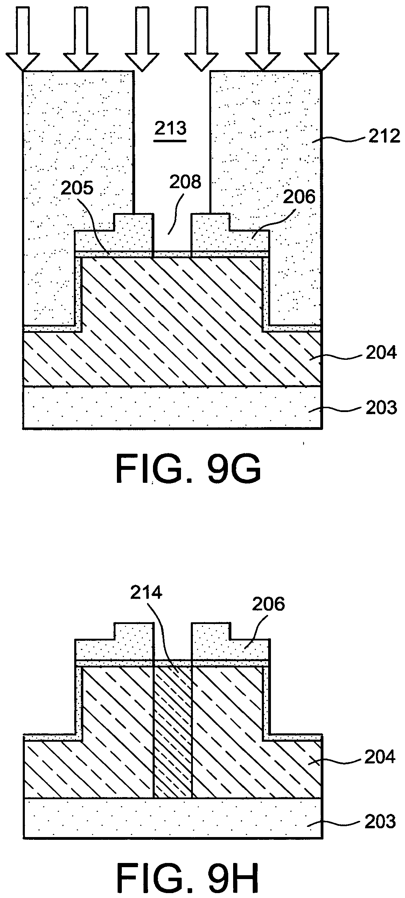

On réalise ensuite la définition lithographique de la zone implantée centrale sur l'arête du guide d'onde. Pour cela, on forme un masque 212 présentant une ouverture 213 (voir la figure 9G). La largeur de l'ouverture 213 est plus grande que la largeur de la fente 208 de façon que ce soit le masque dur 206 qui définisse la largeur de la zone implantée. La largeur de la zone implantée est supérieure à F+2Ta et inférieure à W-2Ta. On procède ensuite à la formation de la zone dopée P par implantation au travers de la fente 208 (symbolisée par des flèches). Avantageusement, l'angle d'implantation est de 0° afin de réduire l'extension latérale de la fente.

L'implantation fournit une zone 214 dopée P parfaitement centrée par rapport à l'arête 210 et la résine est éliminée (voir la figure 9H).

La région dopée P correspondant à la région 25 de la figure 5 est réalisée au cours d'un autre niveau de masquage.

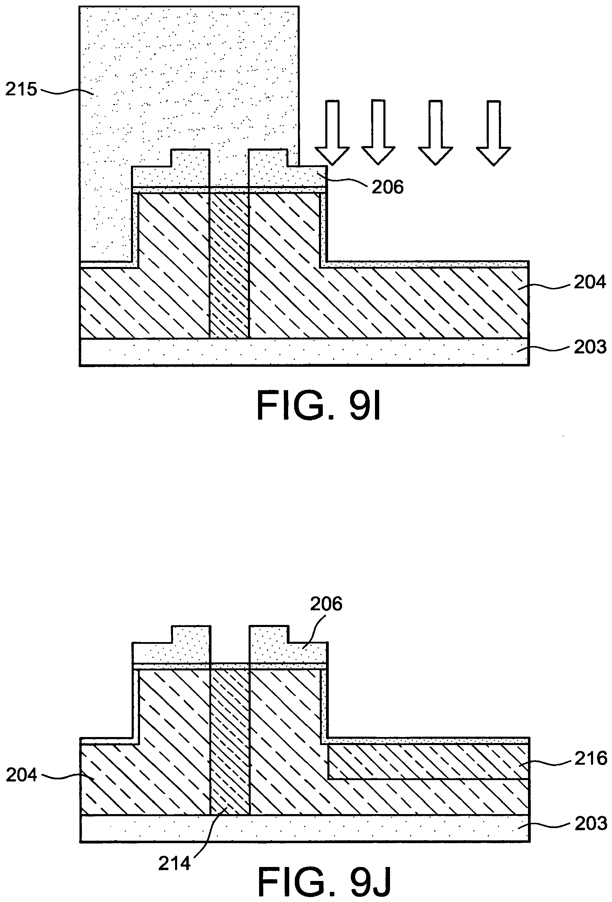

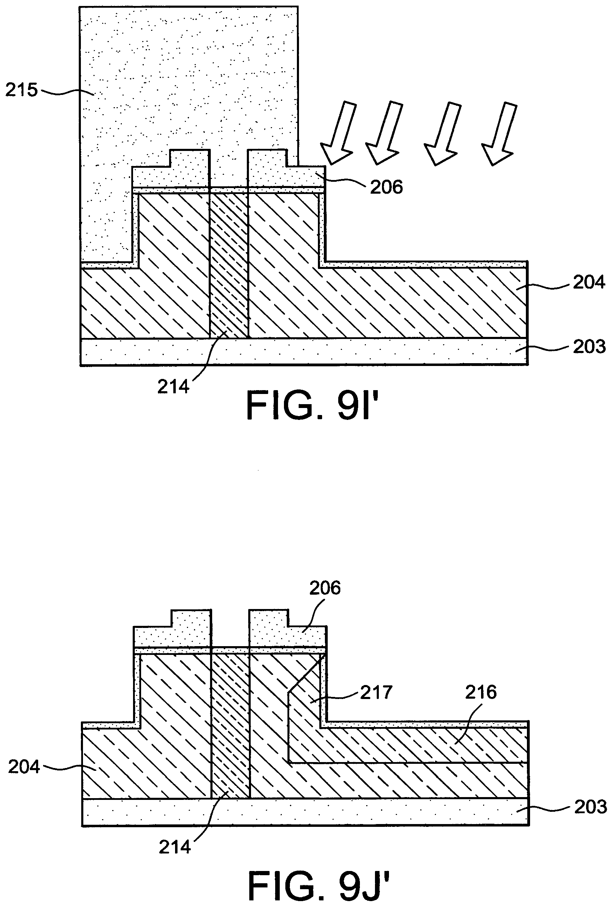

On va ensuite réaliser le dopage de la région N. Pour cela, on forme par lithographie un masque 215 sur les parties à protéger de la structure obtenue à la figure 9H. Ceci est illustré par la figure 9I qui montre le masque 215 qui laisse partiellement visible une partie du masque dur 206 situé du côté de la région à implanter. Du fait de la présence de ce masque dur, la tolérance d'alignement reste la même Ta=±(W-F)/4. Dans le cas illustré par la figure 9I, l'implantation (symbolisée par des flèches) se fait avec un angle de 0° sur une profondeur au moins égale à l'épaisseur de silicium restante au-dessus de la couche d'oxyde enterrée 204 après la gravure de l'arête (200 nm par exemple). Dans ce cas, la région implantée N est auto-alignée avec le bord de l'arête par la présence du masque dur 206.

La figure 9J montre la structure obtenue après élimination du masque de résine. Cette figure montre la région dopée N 216 obtenue. Le masque dur 206 peut ensuite être éliminé, par exemple par gravure chimique.

Les figures 9I' et 9J' sont des vues en coupe transversale illustrant une variante du premier mode de réalisation. Cette variante de réalisation est appliquée sur la structure représentée à la figure 9H.

Le même masquage lithographique que pour le mode de réalisation décrit précédemment est mis en oeuvre. Un masque 215 est donc formé comme pour la figure 9I. La différence par rapport au mode de réalisation précédent est que l'implantation ionique est effectuée avec un angle différent de 0°, par exemple 20°, afin de doper (par exemple sur 100 nm de profondeur) le flanc de l'arête non masqué ainsi que la région d'accès. Cet effet peut aussi être obtenu en utilisant une implantation plasma. La figure 9I' illustre l'implantation ionique sous un angle défini. La figure 9J' montre le résultat obtenu après élimination du masque de résine. La référence 216 désigne la région dopée N comme sur la figure 9J, la référence 217 désigne la zone dopée N située sur le flanc de l'arête.

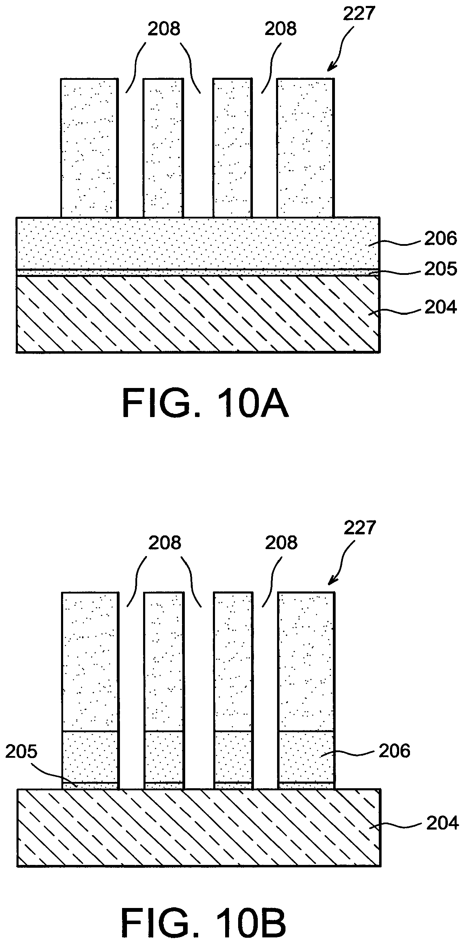

En cas de besoin, plusieurs zones peuvent être implantées dans l'arête. Pour cela, sur la structure de départ constituée d'un substrat SOI comprenant (voir la figure 10A) un support, une couche d'oxyde enterrée (le support et la couche d'oxyde ne sont pas représentés par souci de simplification) et une couche mince de silicium, recouvert d'une fine couche d'oxyde de silicium 205 et d'une couche de silice 206 formant masque dur, on forme par lithographie un masque de résine 227 présentant plusieurs fentes 228 pour la définition de zones dopées P.

La figure 10B correspond à la figure 9B. Les parties non masquées du masque dur 206 et de la fine couche d'oxyde de silicium 205 sont gravées jusqu'à révéler la couche mince de silicium 204. La suite du procédé se déroule alors comme précédemment décrit.

Les figures 11A à 11G sont des vues en coupe transversale illustrant un deuxième mode de réalisation d'un modulateur électro-optique latéral sur silicium, selon la présente invention.

Les premières étapes de ce deuxième mode de réalisation sont identiques aux premières étapes du premier mode de réalisation. Elles ne seront donc pas illustrées par des dessins.

La figure 11A représente la structure au cours du même stade de fabrication que la structure représentée à la figure 9D. Dans ce deuxième mode de réalisation, le motif du masque de résine 209 protégeant la fente 208 est défini avec plus de précision à la fois sur sa largeur et sur son alignement afin de définir la zone implantée N. La tolérance d'alignement du masque de résine 209 par rapport au masque dur 206 est la meilleure possible, donc inférieure à $\pm(W-F)/4$. Par exemple si W = 500 nm et F = 100 nm, alors Ta < 100 nm. La largeur P du masque de résine 209 est :

$$F + 2Ta < P < W - 2Ta - Dn$$

où Dn est la largeur désirée de la zone N sur l'arête du guide d'onde.

La structure obtenue précédemment est soumise à une étape de gravure du silicium de la couche 204 pour définir l'arête 210 nécessaire pour le guidage optique. C'est ce qui est représenté à la figure 11B. Pendant la gravure du silicium, le masque dur 206 a été partiellement consommé dans sa partie non masquée par le masque de lithographie 209, ce qui se traduit par un profil en forme de marche.

En utilisant à nouveau le masque de résine 209, on procède à la gravure de la partie non masquée du masque dur 206. C'est ce que montre la figure 11C. Cette étape définit l'extension de la zone dopée N de largeur Dn.

Le masque de résine 209 est ensuite éliminé et une fine couche d'oxyde de silicium 211 est formée sur la couche mince de silicium 204 qui a ét révélée précédemment. C'est ce que montre la figure 11D. On réalise ensuite la définition lithographique de la zone implantée centrale sur l'arête du guide d'onde. Pour cela, on forme un masque 222 présentant une ouverture 223 (voir la figure 11D). La largeur de l'ouverture 223 est plus grande que la largeur de la fente 208 de façon que ce soit le masque dur 206 qui définisse la largeur de la zone implantée. La largeur de l'ouverture 223 ainsi que la tolérance d'alignement sont plus précises (par exemple, diminution d'un facteur 2 sur Ta). On procède ensuite à la formation de la zone dopée P par implantation au travers de la fente 208 (symbolisée par des flèches). Avantageusement, l'angle d'implantation est de 0° afin de réduire l'extension latérale de la fente.

L'implantation fournit une zone 214 dopée P parfaitement centrée par rapport à l'arête 210 et la résine est éliminée (voir la figure 11E).

La région dopée P correspondant à la région 25 de la figure 5 est réalisée par la suite.

On va ensuite réaliser le dopage de la région N. Pour cela, on forme par lithographie un masque 225 sur les parties à protéger de la structure obtenue à la figure 11E. Ceci est illustré par la figure 11F qui montre le masque 225 qui laisse partiellement visible une partie du masque dur 206 situé du côté de la région à implanter. En raison de la gravure du masque dur 206 (voir la figure 11C), la tolérance d'alignement du masque de résine 225 par rapport au masque dur 206 est de Ta = $\pm(W-F)/8$. A titre d'exemple, W = 500 nm, F = 10 nm et Ta = $\pm50$ nm. La tolérance d'alignement est identique à celle pour l'implantation de la fente. On implante préférentiellement à 0°.

Dans le cas illustré sur la figure 11F, l'implantation (symbolisée par des flèches) se fait sur une profondeur au moins égale à l'épaisseur de silicium restante au-dessus de la couche d'oxyde enterrée 204 après la gravure de l'arête (200 nm par exemple).

La figure 11G montre la structure obtenue après élimination du masque de résine. Cette figure montre la région dopée N 316 obtenue et qui se prolonge dans l'arête du guide d'onde 210 par une zone dopée N 317. Le masque dur 206 peut ensuite être éliminée.

## Revendications

1. Procédé de fabrication d'un modulateur électro-optique latéral sur un substrat SOI, le modulateur comprenant un guide d'onde en arête formé dans la couche mince de silicium (204) du substrat SOI, le guide d'onde en arête étant placé entre une région dopée P et une région dopée N formées dans la couche mince de silicium, le guide d'onde en arête occupant une région intrinsèque de la couche mince, la région dopée P, la région intrinsèque et la région dopée N constituant une structure de diode PIN, au moins une zone dopée P (214) étant formée dans l'arête (210) et perpendiculairement au substrat,
le procédé comprenant des étapes :

   - de masquage de la couche mince de silicium (204), mettant en oeuvre un masque dur (206) dont le motif permet d'y définir l'arête du guide d'onde,
   - d'obtention de l'arête par gravure de la couche mince de silicium (204), un premier masque de résine (209) recouvrant le masque dur (206) pour protéger les parties à doper P,
   - de masquage de la couche mince de silicium (204) pour délimiter les parties à doper P,
   - de dopage des parties à doper P,
   - de masquage de la couche mince de silicium pour délimiter la région à doper N et
   - de dopage de la région à doper N,

   **caractérisé en ce que** ledit premier masque de résine (209) recouvre partiellement le masque dur (206), et **en ce que**

   lesdites étapes de masquage permettent également de définir la zone à doper P (214) dans l'arête du guide d'onde grâce au masque dur (206) et à un deuxième masque de résine (212, 222) présentant une ouverture (213) dont la largeur est plus grande que la largeur de la zone à doper P (214) de façon que ce soit le masque dur (206) qui définisse la largeur de la zone dopée P, et de définir la limite de la région à doper N (216, 316) par rapport à l'arête du guide d'onde grâce au masque dur (206) et à un troisième masque de résine (215, 225) qui laisse partiellement visible une partie du masque dur (206) située du côté de la région à doper N.

2. Procédé selon la revendication 1, dans lequel le masque dur (206) est formé par gravure d'une couche de matériau de masque dur.

3. Procédé selon l'une quelconque des revendications 1 ou 2, dans lequel le masque dur (206) est réalisé en un matériau choisi parmi la silice, le titane et le nitrure de silicium.

4. Procédé selon l'une quelconque des revendications 1 à 3, dans lequel le motif du masque dur (206) présente des bords extérieurs qui définissent l'arête du guide d'onde, une fente interne (208) qui définit la zone à doper P (214) dans l'arête du guide d'onde, l'un desdits bords extérieurs définissant la limite de la région dopée N par rapport à l'arête du guide d'onde.

5. Procédé selon la revendication 4, comprenant la succession d'étapes suivantes :

   - formation du premier masque de résine (209) sur le masque dur (206), le premier masque de résine recouvrant la fente (208) du masque dur et étant en retrait par rapport aux bords extérieurs du masque dur qui définissent l'arête du guide d'onde,
   - gravure des parties non masquées de la couche mince de silicium (204) pour obtenir l'arête (210) du guide d'onde,
   - élimination du premier masque de résine (209),
   - formation du deuxième masque de résine (212, 222) masquant les parties de la structure ne devant pas être dopées P, le deuxième masque de résine (212, 222) comprenant une fente (213, 223) dont les bords sont en retrait par rapport aux bords de la fente (208) du masque dur (206),
   - réalisation du dopage P des parties non masquées de la couche mince de silicium (204),
   - élimination du deuxième masque de résine (212, 222),
   - formation du troisième masque de résine (215, 225) masquant les parties de la structure ne devant pas être dopées N, le bord du troisième masque de résine du côté de la région à doper N étant en retrait par rapport au bord correspondant du masque dur (206),
   - réalisation du dopage N des parties non masquées de la couche mince de silicium (204),
   - élimination du troisième masque de résine (215, 225),
   - élimination du masque dur (206).

6. Procédé selon la revendication 5, dans lequel le dopage N est réalisé par implantation ionique selon un angle de 0° par rapport à une direction verticale au substrat SOI.

7. Procédé selon la revendication 5, dans lequel le dopage N est réalisé par implantation ionique selon un angle déterminé par rapport à une direction verticale au substrat SOI afin de doper le flanc (217) de l'arête du guide d'onde adjacent à la région dopée N (216).

8. Procédé selon la revendication 5, dans lequel le dopage N est réalisé par implantation ionique de type plasma afin de doper le flanc (217) de l'arête du guide d'onde adjacent à la région dopée N (216).

9. Procédé selon la revendication 5, comprenant en outre, entre l'étape de gravure de la couche mince de silicium (204) et l'étape d'élimination du premier masque de résine (209), une étape de gravure complète des parties du masque dur (206) non masquées par le premier masque de résine (209).

**Patentansprüche**

1. Verfahren zum Herstellen eines seitlichen, elektrooptischen Modulators auf einem SOI-Substrat, wobei der Modulator einen Stegwellenleiter enthält, der in der Silicium-Dünnschicht (204) des SOI-Substrats ausgebildet ist, wobei der Stegwellenleiter zwischen einem p-dotierten Bereich und einem n-dotierten Bereich angeordnet ist, die in der Silicium-Dünnschicht ausgebildet sind, wobei der Stegwellenleiter einen intrinsischen Bereich der Dünnschicht einnimmt, der p-dotierte Bereich, der intrinsische Bereich und der n-dotierte Bereich eine pin-Diodenstruktur bilden, wobei zumindest eine p-dotierte Zone (214) in dem Steg (210) ausgebildet ist und senkrecht zum Substrat verläuft, wobei das Verfahren die nachfolgenden Schritte umfasst:

    - Maskieren der Silicium-Dünnschicht (204), indem eine Hartmaske (206) eingesetzt wird, deren Muster gestattet, den Steg des Wellenleiters darauf zu definieren,
    - Erhalten des Stegs durch Ätzen der Silicium-Dünnschicht (204), wobei eine erste Harzmaske (209) die Hartmaske (206) überdeckt, um die mit p zu dotierenden Teile abzuschirmen,
    - Maskieren der Silicium-Dünnschicht (204), um die mit p zu dotierenden Teile einzugrenzen,
    - Dotieren der mit p zu dotierenden Teile,
    - Maskieren der Silicium-Dünnschicht, um den mit n zu dotierenden Bereich einzugrenzen, und
    - Dotieren des mit n zu dotierenden Bereichs,

    **dadurch gekennzeichnet, dass**
    die erste Harzmaske (209) die Hartmaske (206) teilweise überdeckt und dass die Schritte des Maskierens auch gestatten, die mit p zu dotierende Zone (214) in dem Steg des Wellenleiters aufgrund der Hartmaske (206) und einer zweiten Harzmaske (212, 222) zu definieren, die eine Öffnung (213) aufweist, deren Breite größer ist als die Breite der mit p zu dotierenden Zone (214), so dass die Hartmaske (206) diejenige ist, die die Breite der p-dotierten Zone definiert, und die Grenze des mit n zu dotierenden Bereichs (216, 316) bezüglich des Stegs des Wellenleiters aufgrund der Hartmaske (206) und einer dritten Harzmaske (215, 225) zu definieren, welche einen Teil der Hartmaske (206) teilweise sichtbar lässt, der auf der Seite des mit n zu dotierenden Bereichs liegt.

2. Verfahren nach Anspruch 1, wobei die Hartmaske (206) durch Ätzen einer Materialschicht der Hartmaske ausgebildet ist.

3. Verfahren nach einem der Ansprüche 1 oder 2, wobei die Hartmaske (206) aus einem Material ausgebildet ist, das aus Siliciumdioxid, Titan und Siliciumnitrid ausgewählt ist.

4. Verfahren nach einem der Ansprüche 1 bis 3, wobei das Muster der Hartmaske (206) Außenränder aufweist, die den Steg des Wellenleiters definieren, sowie einen inneren Schlitz (208), der die mit p zu dotierende Zone (214) in dem Steg des Wellenleiters definiert, wobei einer der Außenränder die Grenze des n-dotierten Bereichs bezüglich des Stegs des Wellenleiters definiert.

5. Verfahren nach Anspruch 4, umfassend die Abfolge der nachstehenden Schritte:

    - Ausbilden der ersten Harzmaske (209) auf der Hartmaske (206), wobei die erste Harzmaske den Schlitz (208) der Hartmaske überdeckt und bezüglich der Außenränder der Hartmaske zurückspringt, die den Steg des Wellenleiters definieren,
    - Ätzen der nicht maskierten Teile der Silicium-Dünnschicht (204), um den Steg (210) des Wellenleiters zu erhalten,
    - Entfernen der ersten Harzmaske (209),
    - Ausbilden der zweiten Harzmaske (212, 222), die die Teile der Struktur maskiert, die nicht mit p dotiert werden dürfen, wobei die zweite Harzmaske (212, 222) einen Schlitz (213, 223) aufweist, dessen Ränder bezüglich der Ränder des Schlitzes (208) der Hartmaske (206) zurückspringen,
    - Herstellen der p-Dotierung der nicht maskierten Teile der Silicium-Dünnschicht (204),
    - Entfernen der zweiten Harzmaske (212, 222),
    - Ausbilden der dritten Harzmaske (215, 225), die die Teile der Struktur maskiert, die nicht mit n dotiert werden dürfen, wobei der Rand der dritten Harzmaske auf der Seite des mit n zu dotierenden Bereichs bezüglich des entsprechenden Randes der Hartmaske (206) zurückspringt,
    - Herstellen der n-Dotierung der nicht maskierten Teile der Silicium-Dünnschicht (204),
    - Entfernen der dritten Harzmaske (215, 225),
    - Entfernen der Hartmaske (206).

6. Verfahren nach Anspruch 5, wobei die n-Dotierung durch Ionenimplantation unter einem Winkel von 0° bezüglich einer zum SOI-Substrat vertikalen Richtung hergestellt wird.

7. Verfahren nach Anspruch 5, wobei die n-Dotierung durch Ionenimplantation unter einem bestimmten Winkel bezüglich einer zum SOI-Substrat vertikalen Richtung hergestellt wird, um die Flanke (217) des Stegs des Wellenleiters zu dotieren, der an den n-dotierten Bereich (216) angrenzt.

8. Verfahren nach Anspruch 5, wobei die n-Dotierung durch Ionenimplantation vom Typ Plasma hergestellt wird, um die Flanke (217) des Stegs des Wellenleiters zu dotieren, der an den n-dotierten Bereich (216) angrenzt.

9. Verfahren nach Anspruch 5, ferner umfassend zwischen dem Schritt des Ätzens der Silicium-Dünnschicht (204) und dem Schritt des Entfernens der ersten Harzmaske (209) einen Schritt des vollständigen Ätzens der Teile der Hartmaske (206), die nicht mit der ersten Harzmaske (209) maskiert sind.

**Claims**

1. A production method for a lateral electro-optical modulator on an SOI substrate, the modulator comprising a rib waveguide formed in the thin layer of silicon (204) of the SOI substrate, the rib waveguide being placed between a doped region P and a doped region N formed in the thin layer of silicon, the rib waveguide occupying an intrinsic region of the thin layer, the doped region P, the intrinsic region and the doped region N constituting a PIN diode structure, at least one doped zone P (214) being formed in the rib (210) and perpendicularly to the substrate, the method comprising steps of:

- masking the thin layer of silicon (204), employing a hard mask (206) whereof the pattern defines therein the rib of the waveguide,
- producing the rib by etching of the thin layer of silicon (204), a first resin mask (209) covering the hard mask (206) to protect the parts to be doped P,
- masking of the thin layer of silicon (204) to delimit the parts to be doped P,
- doping the parts to be doped P,
- masking the thin layer of silicon to delimit the region to be doped N and
- doping the region to be doped N,

**characterised in that** said first resin mask (209) partially covers the hard mask (206) and **in that** said masking steps likewise define the zone to be doped P (214) in the rib of the waveguide due to the hard mask (206) and to a second resin mask (212) having an opening (213) whose width is greater than the width of the zone to be doped P such that it is the hard mask (206) which defines the width of the doped zone P, and define the limit of the doped region N (216, 316) relative to the rib of the waveguide due to the hard mask (206) and to a third resin mask (215) which leaves part of the hard mask (206) partially visible located to the side of the region to be doped N.

2. The method as claimed in Claim 1, wherein the hard mask (206) is formed by etching of a layer of hard mask material.

3. The method as claimed in one of Claims 1 or 2, wherein the hard mask (206) is made of a material selected from silica, titanium and silicon nitride.

4. The method as claimed in one of Claims 1 to 3, wherein the pattern of the hard mask (206) has external edges which define the rib of the waveguide, an internal slot (208) which defines the zone to be doped P (214) in the rib of the waveguide, which has said external edges defining the limit of the doped region N relative to the rib of the waveguide.

5. The method as claimed in Claim 4, comprising the succession of following steps:

- formation of the first resin mask (209) on the hard mask (206), the first resin mask covering the slot (208) of the hard mask and being recessed relative to the external edges of the hard mask which define the rib of the waveguide,
- etching the unmasked parts of the thin layer of silicon (204) to produce the rib (210) of the waveguide,
- elimination of the first resin mask (209),
- formation of the second resin mask (212, 222) masking the parts of the structure not having to be doped P, the second resin mask (212, 222) comprising a slot (213, 223) whereof the edges are recessed relative to the edges of the slot (208) of the hard mask (206),
- performing the doping P of the unmasked parts of the thin layer of silicon (204),
- elimination of the second resin mask (212, 222),
- formation of the third resin mask (215, 225) masking the parts of the structure not having to be doped N, the edge of the third resin mask to the side of the region to be doped N being recessed relative to the corresponding edge of the hard mask (206),
- performing the doping N of the unmasked parts of the thin layer of silicon (204),
- elimination of the third resin mask (215, 225),
- elimination of the hard mask (206).

6. The method as claimed in Claim 5, wherein the doping N is performed by ionic implantation according to an angle of 0° relative to a direction vertical to the SOI substrate.

7. The method as claimed in Claim 5, in which the doping N is performed by ionic implantation according to an angle determined relative to a direction vertical to the SOI substrate so as to dope the flank (217) of the rib of the waveguide adjacent to the doped region N (216).

8. The method as claimed in Claim 5, wherein the doping N is performed by ionic implantation of plasma type for doping the flank (217) of the rib of the waveguide adjacent to the doped region N (216).

9. The method as claimed in Claim 5, comprising also, between the etching step of the thin layer of silicon (204) and the elimination step of the first resin mask (209), a complete etching step of the parts of the hard mask (206) not masked by the first resin mask (209).

FIG. 1

FIG. 4

FIG. 2

FIG. 3

FIG. 5

FIG. 6A

32

31

33

24

23

## FIG. 6B

34

31

33

34

24

23

## FIG. 6C

14

FIG. 6D

FIG. 6E

**FIG. 6F**

**FIG. 6G**

# FIG. 7

# FIG. 8

FIG. 9A

FIG. 9B

208

206

205

204

203

## FIG. 9C

209

206

204

203

## FIG. 9D

## FIG. 9E

## FIG. 9F

213

212

205 208 206

204

203

# FIG. 9G

214 206

204

203

# FIG. 9H

215

206

204

203

## FIG. 9I

206

204

216

203

214

## FIG. 9J

215

206

204

203

214

# FIG. 9I'

206

217    216

204

214

203

# FIG. 9J'

FIG. 10A

FIG. 10B

FIG. 11A

FIG. 11B

209

206

210

Dn

204

203

# FIG. 11C

223

206

222

208

211

205

204

203

# FIG. 11D

206

210

204

203

214

# FIG. 11E

225

206

204

203

# FIG. 11F

FIG. 11G

**EP 2 177 944 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7251408 B
- US 7116853 B
- WO 2005093480 A
- GB 2373921 A

**Littérature non-brevet citée dans la description**

- **D. MARRIS-MORINI et al.** *Optics Express,* 07 Janvier 2008, vol. 16 (1), 334-339